Europäisches Patentamt

European Patent Office

Office européen des brevets

(11) Publication number: **0 043 707**
**B1**

# (12) EUROPEAN PATENT SPECIFICATION

(45) Date of publication of patent specification: **26.09.84**

(21) Application number: **81303025.1**

(22) Date of filing: **02.07.81**

(51) Int. Cl.³: **H 03 F 3/72,** H 03 F 3/30

(54) Audio-frequency power amplifier.

(30) Priority: **04.07.80 JP 90537/80**

(43) Date of publication of application:
**13.01.82 Bulletin 82/02**

(45) Publication of the grant of the patent:
**26.09.84 Bulletin 84/39**

(84) Designated Contracting States:
**DE FR GB NL**

(56) References cited:
**DE-A-2 261 139**
**DE-B-2 658 278**
**US-A-3 768 031**
**US-A-3 808 545**

(73) Proprietor: **FUJITSU LIMITED**
**1015, Kamikodanaka Nakahara-ku**
**Kawasaki-shi Kanagawa 211 (JP)**

(72) Inventor: **Honda, Hideo 1578-54, Ko**
**Aza Tateishikuchi Oaza Hachiman Ikkimachi**
**Aizuwakamatsu-shi Fukushima 965 (JP)**
Inventor: **Hanazawa, Toshio**
**95-4-23, Shimokodanaka**
**Nakahara-ku Kawasaki-shi Kanagawa 211 (JP)**
Inventor: **Tsuchiya, Chikara**
**2-26-5, Honmachi**
**Shibuya-ku Tokyo 151 (JP)**
Inventor: **Handa, Harumi**
**525, Shimokodanaka**
**Nakahara-ku Kawasaki-shi Kanagawa 211 (JP)**
Inventor: **Sano, Yoshiaki**
**3-12-24-101, Miyamaedaira**
**Takatsu-ku Kawasaki-shi Kanagawa 213 (JP)**

(74) Representative: **George, Sidney Arthur et al**
**GILL JENNINGS & EVERY 53-64 Chancery Lane**
**London WC2A 1HN (GB)**

Courier Press, Leamington Spa, England.

## Description

This invention relates to a low-frequency direct-coupled power amplifier connected in a bridged configuration.

A direct-coupled power amplifier connected in a bridged configuration, in other words a bridged transformerless power amplifier (BTL power amplifier), comprises main and inverse amplifier units having the same constitution but producing inverted outputs relative to each other. A low-impedance load, such as a loudspeaker, is directly connected between the output ports of the main and inverse amplifier units. An example of such a BTL power amplifier is disclosed in United States Patent No. 3,808,545.

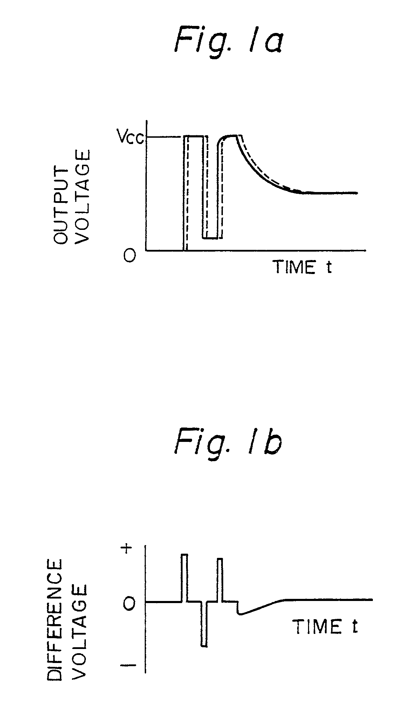

If outputs appear from the main and inverse amplifier units of a BTL power amplifier and, furthermore, if there is a phase difference between the outputs, as shown by solid and broken lines in Fig. 1a of the accompanying drawings, when the power supply is switched on, pulse signals corresponding to the difference in the voltage, as shown in Fig. 1b, are applied to the loudspeaker. Hence, transient noises, such as so-called "pop noises" are often heard from the loudspeakers when the power is applied.

It is, therefore, an object of the present invention to provide an audio-frequency power amplifier of the BTL type in which pop noises are prevented from occurring when power is applied thereto.

According to the present invention, there is provided an audio-frequency power amplifier comprising a power switch, first amplifying means including a first output stage for producing an output, second amplifying means including a second output stage for producing an output having an inverted phase relative to the phase of the output from the first output stage, and a low-impedance load directly connected between output ports of the first and second output stages; characterised by first operation control means for activating the first output stage, the activation being begun after the closing of the power switch; and second operation control means for maintaining the output port of the second output stage in a floating state for a first predetermined period of time after the activation of the first output stage is begun.

An embodiment of the invention will now be described, by way of example, with reference to the accompanying drawings, in which:

Figs. 1a and 1b are graphs illustrating the occurrence of pop noises in conventional amplifiers;

Fig. 2 is a schematic block diagram illustrating the concept of the present invention;

Fig. 3 is a block diagram of an amplifier according to the present invention;

Fig. 4 is a graph showing the variation of voltages $v_i$, $v_f$, $v_B$ with time t; and

Fig. 5 is a detail circuit diagram of a main amplifier unit of Fig. 3.

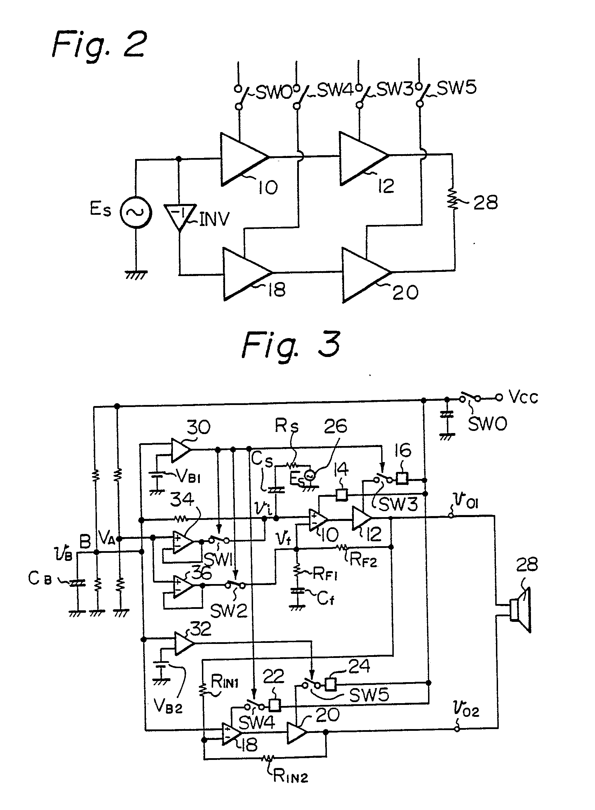

Fig. 2, which illustrates the concept of the present invention, shows an input stage 10 of a main amplifier unit, an output stage 12 of the main amplifier unit, an input stage 18 of an inverse amplifier unit, and an output stage 20 of the inverse amplifier unit. A low-impedance load 28, such as a loudspeaker, is directly connected between output ports of the output stages 12 and 20.

A signal from a signal source $E_s$ is applied to the input stage 10 without inversion, and is inverted at an inverter INV and then applied to the input stage 18. Therefore, although the structure and function of the main amplifier unit are the same as the structure and function of the inverse amplifier unit, the output signals from the amplifier units are inverted relative to each other.

Switches SW0, SW4, SW3 and SW5 break or make connections in bias supply circuits for the respective stages 10, 18, 12 and 20. If the switches are turned on, the bias voltages are supplied to the respective stages, causing the stages to be active. On the other hand, if the switches are turned off, no bias voltages are supplied, so that the respective stages are in a floating state.

According to the present invention, these switches SW0, SW4, SW3 and SW5 are turned on, in order, at various intervals, so as to prevent pop noises from occurring. First, only the switch SW0 is turned on, causing the input stage 10 to be active. Next, the switches SW4 and SW3 are turned on after a time period $T_a$, causing the input stage 18 and the output stage 12 to be active. During the period $T_a$, capacitances connected to the input port of the input stage 10 are fully charged. Then the switch SW5 is turned on after a further period $T_b$, causing the output stage 20 to be active. During the periods $T_a$ and $T_b$, capacitances for stabilising the bias voltage applied to this power amplifier are fully charged.

During the period $T_a$, since the output impedances of the main and invert amplifier units are very high, because the output stages 12 and 20 are in a floating state, no voltage develops across the low impedance load 28. Namely, pop noises are not produced. Furthermore, during the period $T_b$, since the output impedance of the inverse amplifier unit is very high, because the output stage 20 is still in a floating state, even though the output stage 12 is active, no voltage develops across the load 28. Since the inverse amplifier unit is activated after the bias voltage of the main amplifier unit is completely stabilised, no pop noises occur at the start of the activation of the output stage 20.

Fig. 3 illustrates an embodiment of the present invention. Input stages 10 and 18, output stages 12 and 20, a low-impedance load 28, and switches SW0, SW4, SW3 and SW5 illustrated in Fig. 3 are the same as those in Fig. 2. Bias circuits 14, 16, 22 and 24 supply the bias voltage to the input stage 10, the output stage 12, the input stage 18 and the output stage 20, respectively. In Fig. 3, the reference 26 denotes the input signal source $E_s$. A comparator 30 compares the voltage developed across a capacitor $C_B$ with a predetermined voltage $V_{B1}$ and generates a first timing signal. A comparator 32 compares the voltage developed across the capacitor $C_B$ with a predetermined voltage $V_{B2}$ and generates a second timing signal. References 34 and 36 denote voltage followers.

Switches SW1 and SW2 are normally-closed switches which are connected in respective charging circuits of an input coupling capacitor $C_s$ which is used for holding-off d.c. signals from the input, and a feed-back capacitor $C_f$ which is used for holding-off d.c. signals of the feedback terminal. These switches SW1 and SW2 turn off in response to the first timing signal from the comparator 30.

The switches SW3 and SW4 are normally-open switches which turn on in response to the first timing signal from the comparator 30. The switch SW3 is connected between the bias circuit 16 and the output stage 12, and the switch SW4 is connected between the bias circuit 22 and the input stage 18. The switch SW5 is a normally-open switch which is connected between the bias circuit 24 and the output stage 20, and turns on in response to the second timing signal from the comparator 32. The voltage $v_B$ developed across the capacitor $C_B$, which is used to stabilise the bias voltage, is, as mentioned, compared with predetermined voltages $V_{B1}$ and $V_{B2}$ by the comparators 30 and 32, respectively. This voltage $v_B$ gradually increases from zero up to the final voltage $V_B$ when the power switch SW0 is turned on.

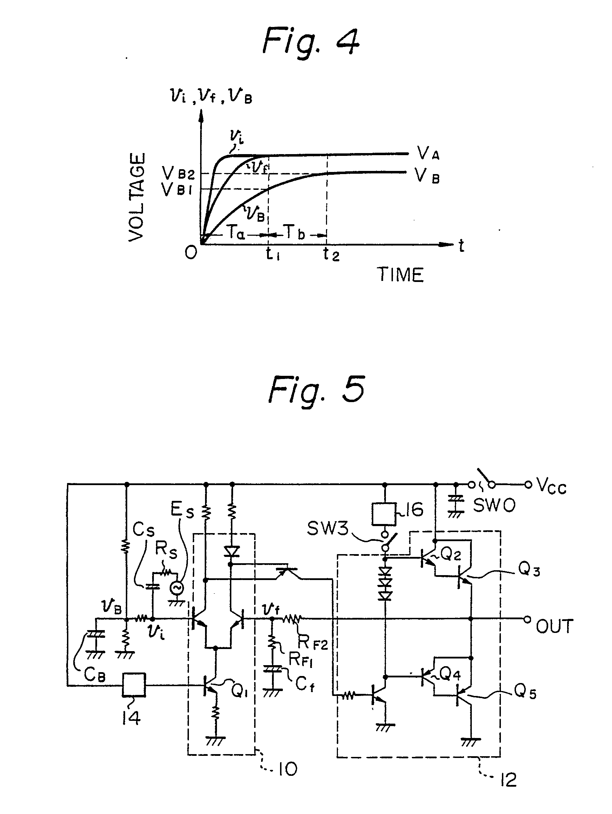

Fig. 4 illustrates variations in voltages $v_i$, $v_f$ and $v_B$ at points in the circuitry of Fig. 3 with respect to time elapsing after the power supply is turned on. With reference to Fig. 4, the operation of the embodiment shown in Fig. 3 will be illustrated.

When the power switch SW0 is turned on, the capacitor $C_B$ is gradually charged and hence the voltage $v_B$ across the capacitor $C_B$ gradually increases as shown in Fig. 4. While the voltage $v_B$ is lower than the predetermined reference voltage $V_{B1}$ of the comparator 30, in other words while the time t elapsed since the power switch is closed is given by $0 < t < t_1$, the capacitors $C_s$ and $C_f$ are charged by the current which is fed thereto via the respective voltage followers 34 and 36 so as to stabilise the bias of the input port of the input stage 10. Furthermore, while $0 < t < t_1$, since both of the switches SW3 and SW5 are opened, no bias voltage is applied to the output stage 12 and to the output stage 20, so that both of the output ports of the main and inverse amplifier units are in a floating state. Therefore, the output impedances of the main and inverse amplifier units are maintained at a very high level, and so the impedance of the load 28 can be neglected. Accordingly, an output $v_{02}$ (Fig. 3) from the inverse amplifier unit follows an output $v_{01}$ from the main amplifier unit, and vice versa, causing no noise to occur from the loudspeaker 28.

When the voltage $v_B$ across the capacitor $C_B$ increases up to $V_{B1}$, the comparator 30 produces a first timing signal and so the switches SW1 and SW2 are turned off, causing the charging operation of the capacitors $C_s$ and $C_f$ to stop. The reference voltage $V_{B1}$ is determined such that the first timing signal is produced from the comparator 30 when the capacitors $C_s$ and $C_f$ are almost fully charged, when the cross voltages are nearly each to $V_A$, and when the bias of the input port of the main amplifier unit is stabilised.

According to this embodiment, as mentioned hereinbefore, since the charging circuit for the bias stabilisation of only the input stage 10 is provided, stabilisation thereof is performed within a very short time.

In response to the first timing signal, furthermore, the switches SW3 and SW4 are turned on. Hence, the bias voltage is supplied to the output stage 12 and to the input stage 18, causing the main amplifier unit and the input stage 18 to be active. This condition is maintained in order to stabilise the output from the main amplifier unit while the voltage $v_B$ is lower than the predetermined reference voltage $V_{B2}$ of the comparator 32, but higher than the reference voltage $V_{B1}$ of the comparator 30, in other words when the time t elapsed after the power switch is closed is given by $t_1 < t < t_2$. Whilst $t_1 < t < t_2$, since the output port of the inverse amplifier unit is still in a floating state, the output $v_{02}$ from the inverse amplifier unit follows the output $v_{01}$ from the main amplifier, i.e. the output $v_{02}$ is equal to the output $v_{01}$. Therefore, no noise occurs.

When the voltage $v_B$ across the capacitor $C_B$ increases up to $V_{B2}$, which is near the finally-stabilised voltage $V_B$ ($V_B > V_{B2}$), the comparator 32 produces a second timing signal, and so the switch SW5 is turned on. When the switch SW5 is closed, the bias voltage is supplied to the output stage 20, causing the inverse amplifier unit to be active. Then, the BTL power amplifier operates in the ordinary way, to effect the signal amplifying operation. Since the present BTL power amplifier initiates the signal amplifying operation at a time $t_2$, after the output of the main amplifier unit is completely stable, no noises, such as pop noises, occur at the beginning of the signal amplifying operation.

Fig. 5 illustrates a detailed circuit construction corresponding to a part of the circuitry of Fig. 3. As is shown in Fig. 5, the input stage 10 of the main amplifier unit comprises a differential amplifier. The bias circuit 14 is connected to the base of a transistor $Q_1$ in the input stage 10. When the bias voltage is supplied from the bias circuit 14, the transistor $Q_1$ becomes conductive, causing the input port 10 to activate. In Fig. 5, the output stage 12 of the main amplifier unit is composed of a push-pull amplifier of complementary symmetry. As apparent from Fig. 5, if the switch SW3 opens, no bias voltage is supplied to power transistors $Q_2$ to $Q_5$ in Darlington configuration, causing the output port to be in a floating state. On the other hand, when the switch SW3 closes the bias voltage is supplied, causing the output stage 12 to be active.

As will be apparent from the foregoing description, the present BTL power amplifier comprises a first operation control circuit, which activates the main amplifier unit after the power switch is closed, and a second operation control circuit, which maintains the output port of the inverse amplifier unit in a floating state for a predetermined period of time after the activation of the main amplifier unit has begun. Therefore, no difference between the output voltages of the main and inverse amplifier units appears until the signal amplifying operation of the BTL power amplifier starts. Furthermore, since the signal amplifying operation is started after the main amplifier unit is fully stabilised, no pop noise occurs.

**Claims**

1. An audio-frequency power amplifier comprising a power switch (SW0), first amplifying means (10, 12) including a first output stage (12) for producing an output, second amplifying means (18, 20) including a second output stage (20) for producing an output having an inverted phase relative to the phase of the output from the first output stage, and a low-impedance load (28) directly connected between output ports of the first and second output stages; characterised by first operation control means (SW3) for activating the first output stage, the activation being begun after the closure of the power switch (SW0); and second operation control means (SW5) for maintaining the output port of the second output stage in a floating state for a first predetermined period of time $(T_b)$ after the activation of the first output stage is begun.

2. An amplifier as claimed in Claim 1, characterised in that the first amplifying means further includes a first input stage (10); in that the first input stage is activated when the power switch (SW0) is closed; and in that the first operation control means (SW3) maintains the first output stage in a floating state for a second predetermined period of time $(T_a)$ after the closing of the power switch.

3. An amplifier as claimed in Claim 1 or Claim 2, characterised in that the second amplifying means further includes a second input stage (18); and in that the first operation control means (SW4) begins to activate the second input stage when a second predetermined period of time $(T_a)$ has passed after the closing of the power switch (SW0), and the second operation control means (SW5) maintains the second output stage in a floating state for the first predetermined period of time $(T_b)$ after the activation of the second input stage is begun.

4. An amplifier as claimed in Claim 1, characterised in that the first amplifying means further includes a first input stage (10) and the second amplifying means further includes a second input stage (18); in that the first input stage (10) is activated from the time the power switch (SW0) is closed, the first operation control means (SW3, SW4) maintains the first output stage (12) and the second input stage (18) in a floating state until a second predetermined period of time $(T_a)$ has passed after the activation of the first input stage (10), and activates the first output stage (12) and the second input stage (18) from the time the second predetermined period $(T_a)$ lapses; and in that the second operation control means (SW5) maintains the second output stage (20) in a floating state until the first predetermined period of time $(T_b)$ has passed after the activation of the first output stage (12) and of the second input stage (18) is begun.

5. An amplifier as claimed in Claim 2 or Claim 4, characterised in that the first operation control means comprises means (30) for comparing a bias voltage $(v_B)$ with a first predetermined voltage $(V_{B1})$ to generate a control signal which indicates the comparison result; and means (16) responsive to the control signal, for supplying a bias voltage to the first output stage (12) to activate that stage, the supplying being carried out only when the control signal indicates that the bias voltage is equal to or greater than the first predetermined voltage.

6. An amplifier as claimed in any preceding claim, characterised in that the second operation control means comprises means (32) for comparing a bias voltage $(v_B)$ with a second predetermined voltage $(V_{B2})$ to generate a control signal which indicates the comparison result; and means (24), responsive to the control signal, for supplying a bias voltage to the second output stage (20) to activate that stage, the supplying being carried out only when the control signal indicates that the bias voltage is equal to or greater than the second predetermined voltage.

7. An amplifier as claimed in Claim 2 or Claim 4, characterised in that the first operation control means includes means (SW1) for quickly stabilising a bias voltage applied to the first input stage (10) by additionally feeding a charging current to said first input stage during the second predetermined period $(T_a)$.

**Patentansprüche**

1. Leistungsverstärker für Audiofrequenzen, mit einem Leistungsschalter (SW0), ersten Verstärkereinrichtungen (10, 12), die eine erste Ausgangsstufe (12) zur Erzeugung eines Ausgangs umfassen, zweiten Verstärkereinrichtungen (18, 20), die eine zweite Ausgangsstufe (20) zur Erzeugung eines Ausgangs umfassen, der eine invertierte Phase relativ zu der Phase des Ausgangs von der ersten Ausgangsstufe hat, und einer, eine niedrige Impedanz aufweisende Last (28), die direkt zwischen den Ausgangsöffnungen der ersten und zweiten Ausgangsstufe angeschlossen ist, gekennzeichnet durch eine erste Betriebssteuereinrichtung (SW3) zur Aktivierung der ersten Ausgangsstufe, wobei die Aktivierung nach Schließen des Leistungsschalters (SW0) begonnen wird, und zweite Operationssteuereinrichtungen (SW5), um die Ausgangsports der zweiten Ausgangsstufe für eine erste vorbestimmte Zeitperiode ($T_b$) in einem schwebenden Zustand zu halten, nachdem die Aktivierung der ersten Ausgangsstufe begonnen wird.

2. Verstärker nach Anspruch 1, dadurch gekennzeichnet, daß die erste Verstärkereinrichtung ferner eine erste Eingangsstufe (10) umfaßt, daß die erste Eingangsstufe aktiviert wird, wenn der Leistungsschalter (SW0) geschlossen wird, und daß die erste Operationssteuereinrichtung (SW3) die erste Ausgangsstufe während einer zweiten vorbestimmten Zeitperiode ($T_a$) nach Schließen des Leistungsschalters in einem schwebenden Zustand hält.

3. Verstärker nach Anspruch 1 oder 2, dadurch gekennzeichnet, daß die zweite Verstärkereinrichtung ferner eine zweite Eingangsstufe (18) umfaßt, und daß die erste Operationssteuereinrichtung (SW4) die zweite Eingangsstufe zu aktivieren beginnt, wenn eine zweite vorbestimmte Zeitperiode ($T_a$) nach Schließen des Leistungsschalters (SW0) verstrichen ist, und die zweite Operationssteuereinrichtung (SW5), nachdem die Aktivierung der zweiten Eingangsstufe begonnen wird, während der ersten vorbestimmten Zeitperiode ($T_b$) in einem schwebenden Zustand hält.

4. Verstärker nach Anspruch 1, dadurch gekennzeichnet, daß die erste Verstärkereinrichtung ferner eine erste Eingangsstufe (10) und die zweite Verstärkereinrichtung ferner eine zweite Eingangsstufe (18) umfaßt, daß die erste Eingangsstufe (10) aktiviert wird, wenn der Leistungsschalter (SW0) geschlossen wird, die erste Betriebssteuereinrichtung (SW3, SW4) die erste Ausgangsstufe (12) und die zweite Eingangsstufe (18) in einem schwebenden Zustand hält, bis eine zweite vorbestimmte Zeitperiode ($T_a$) nach Aktivierung der ersten Eingangsstufe (10) verstrichen ist, und die erste Ausgangsstufe (12) und die zweite Eingangsstufe (18) von der Zeit an, wenn die zweite vorbestimmte Periode ($T_a$) abläuft, aktiviert, und daß die zweite Betriebssteuereinrichtung (SW5) die zweite Ausgangsstufe (20) in einem schwebenden Zustand hält, bis die erste vorbestimmte Zeitperiode ($T_b$), nach Beginn der Aktivierung der ersten Ausgangsstufe (12) und der zweiten Eingangsstufe (18), abgelaufen ist.

5. Verstärker nach Anspruch 2 oder 4, dadurch gekennzeichnet, daß die erste Operationssteuereinrichtung eine Einrichtung (30) zum Vergleich einer Vorspannung ($V_B$) mit einer ersten vorbestimmten Spannung ($V_{B1}$) umfaßt, um ein Steuersignal zu erzeugen, welches das Vergleichsergebnis anzeigt, und Einrichtungen (16), die auf das Steuersignal ansprechen, um der ersten Ausgangsstufe (12) eine Vorspannung zuzuführen, um die Stufe zu aktivieren, wobei die Zuführung nur dann durchgeführt wird, wenn das Steuersignal anzeigt, daß die Vorspannung gleich oder größer als die erste vorbestimmte Spannung ist.

6. Verstärker nach einem der vorhergehenden Ansprüche, dadurch gekennzeichnet, daß die zweite Operationssteuereinrichtung Einrichtungen (32) zum Vergleich einer Vorspannung ($V_B$) mit einer zweiten vorbestimmten Spannung ($V_{B2}$) umfaßt, um ein Steuersignal zu erzeugen, welches das Vergleichsergebnis anzeigt, und Einrichtungen (24), welche auf das Steuersignal ansprechen, um eine Vorspannung zu der zweiten Ausgangsstufe (20) zu liefern, um diese zu aktivieren, wobei die Zuführung nur dann durchgeführt wird, wenn das Steuersignal anzeigt, daß die Vorspannung gleich oder größer als die zweite vorbestimmte Spannung ist.

7. Verstärker nach Anspruch 2 oder 4, dadurch gekennzeichnet, daß die erste Operationssteuereinrichtung eine Einrichtung (SW1) zur schnellen Stabilisierung einer Vorspannung umfaßt, welche der ersten Eingangsstufe (10) zugeführt wird, indem während der zweiten vorbestimmten Zeitperiode ($T_a$) zusätzlich ein Ladestrom zu der ersten Eingangsstufe geführt wird.

**Revendications**

1. Amplificateur de puissance pour audiofréquence comprenant un interrupteur d'alimentation électrique (SW0), un premier moyen amplificateur (10, 12) comportant un premier étage de sortie (12) qui produit un signal de sortie, un deuxième moyen amplificateur (18, 20) comportant un deuxième étage de sortie (20) qui produit un signal de sortie dont la phase est inversée par rapport à la phase du signal de sortie dudit premier étage de sortie, et une charge de faible impédance (28) directement connectée entre les sorties du premier et deuxième étages de sortie; caractérisé par un premier moyen de commande de fonctionnement (SW3) servant à actionner le premier étage de sortie, l'actionnement commençant après la fermeture de l'interrupteur d'alimentation électrique (SW0); et un deuxième moyen de commande de fonctionnement (SW5) servant à maintenir la sortie du deuxième étage de sortie dans un état flottant pendant une première durée prédéterminée ($T_b$) après que l'actionnement du premier étage de sortie a commencé.

2. Amplificateur selon la revendication 1, caractérisé en ce que le premier moyen amplificateur comporte en outre un premier étage de sortie (10); en ce que le premier étage de sortie est rendu actif lorsque l'interrupteur d'alimentation électrique (SW0) se ferme; et en ce que le premier moyen de commande de fonctionnement (SW3) maintient le premier étage de sortie dans un état flottant pendant une deuxième durée prédéterminée ($T_a$) après la fermeture de l'interrupteur d'alimentation électrique.

3. Amplificateur selon la revendication 1 ou 2, caractérisé en ce que le deuxième moyen amplificateur comporte en outre un deuxième étage d'entrée (18); et en ce que le premier moyen de commande de fonctionnement (SW4) commence à rendre actif le deuxième étage de sortie lorsqu'une deuxième durée prédéterminée ($T_a$) s'est écoulée après la fermeture de l'interrupteur d'alimentation électrique (SW0), et le deuxième moyen de commande de fonctionnement (SW5) maintient le deuxième étage de sortie dans un état flottant pendant la première durée prédéterminée ($T_b$) après que l'actionnement du deuxième étage d'entrée a commencé.

4. Amplificateur selon la revendication 1, caractérisé en ce que le premier moyen amplificateur comporte en outre un premier étage d'entrée (10) et le deuxième moyen amplificateur comporte en outre un deuxième étage d'entrée (18); en ce que le premier étage d'entrée (10) est actionné à partir de l'instant où l'interrupteur d'alimentation électrique (SW0) est fermé, le premier moyen de commande de fonctionnement (SW3, SW4) maintient le premier étage de sortie (12) et le deuxième étage d'entrée (18) dans un état flottant jusqu'à ce qu'une deuxième période prédéterminée ($T_a$) se soit écoulée après l'actionnement du premier étage d'entrée (10), et actionne le premier étage de sortie (12) et le deuxième étage d'entrée (18) à partir de l'instant où la deuxième période ($T_a$) s'est écoulée; et en ce que le deuxième moyen de commande de fonctionnement (SW5) maintient le deuxième étage de sortie (20) dans un état flottant jusqu'à ce que la première période prédéterminée ($T_b$) se soit écoulée après que l'actionnement du premier étage de sortie (12) et du deuxième étage d'entrée (18) ait commencé.

5. Amplificateur selon la revendication 2 ou 4, caractérisé en ce que le premier moyen de commande de fonctionnement comprend un moyen (30) permettant de comparer une tension de polarisation ($v_B$) avec une première tension prédéterminée ($V_{B1}$) afin de produire un signal de commande qui indique le résultat de la comparaison; et un moyen (16) répondant au signal de commande en délivrant une tension de polarisation au premier étage de sortie (12) afin d'actionner cet étage, l'alimentation ne s'effectuant que lorsque le signal de commande indique que la tension de polarisation est égale ou supérieure à la première tension prédéterminée.

6. Amplificateur selon l'une quelconque des revendications précédentes, caractérisé en ce que le deuxième moyen de commande de fonctionnement comprend un moyen (32) permettant de comparer une tension de polarisation ($v_B$) avec une deuxième tension prédéterminée ($V_{B2}$) afin de produire un signal de commande qui indique le résultat de la comparaison; et un moyen (24) qui répond au signal de commande en délivrant une tension de polarisation au deuxième étage de sortie (20) afin d'actionner cet étage, l'alimentation n'étant effectuée que lorsque le signal de commande indique que la tension de polarisation est égale ou supérieure à la deuxième tension prédéterminée.

7. Amplificateur selon la revendication 2 ou 4, caractérisée en ce que le premier moyen de commande de fonctionnement comporte un moyen (SW1) permettant de stabiliser rapidement la tension de polarisation appliquée au premier étage d'entrée (10) par la délivrance supplémentaire d'un courant de charge audit premier étage d'entrée pendant la deuxième période prédéterminée ($T_a$).

# Fig. Ia

# Fig. Ib

# Fig. 2

# Fig. 3

## Fig. 4

## Fig. 5